# DEMANDE DE BREVET EUROPEEN

(11) **EP 4 761 058 A1**
(43) Date de publication de la demande: **17.06.2026**
(21) Numéro de dépôt: 25218600.2
(22) Date de dépôt: 26.11.2025
(51) Int. Cl.: H02J 13/00, G01R 19/25, G01R 22/06

(54) **DISPOSITIF ELECTRIQUE ET PROCEDE DE DETECTION DE FRAUDE PAR CONTOURNEMENT**

(30) Priorité: 10.12.2024 FR 2413803
(71) Demandeur: SAGEMCOM ENERGY & TELECOM SAS, 92270 Bois-Colombes (FR)
(72) Inventeur: TEBOULLE, Henri, 92270 BOIS-COLOMBES (FR); GRINCOURT, Christophe, 92270 BOIS-COLOMBES (FR)
(74) Mandataire: Novagraaf Technologies

(57) **Abrégé**

Compteur destiné à être monté entre un réseau électrique et une installation électrique, le réseau électrique comportant un ou plusieurs conducteurs de phase et un conducteur de neutre, et l'installation électrique étant configurée pour fonctionner en mode consommation d'énergie ou en mode production d'énergie. Le dispositif comporte un relais de puissance sur chaque conducteur de phase, et au moins un ensemble à microprocesseur configuré pour effectuer les opérations suivantes :
- déterminer que l'installation électrique fonctionne en mode de production d'énergie,
- ouvrir le ou les relais de puissance,
- obtenir une mesure du courant circulant dans le conducteur de neutre, et
- générer une alerte en fonction de ladite mesure lorsque le courant circulant dans le conducteur de neutre est supérieur à un second seuil.

## Description

### DOMAINE TECHNIQUE

Les différents exemples de réalisation décrits dans la présente divulgation concernent un dispositif électrique, particulièrement un compteur électrique pour installation électrique pouvant fonctionner en mode consommation d'énergie ou en mode production d'énergie (par exemple installation pourvue de panneaux solaires ou d'éoliennes). Ils concernent également un procédé de détection de fraude par contournement (ou bypass en anglais) dans une telle installation.

### ARRIERE PLAN

L'installation électrique est reliée via le compteur électrique à un réseau électrique comportant un ou plusieurs conducteurs de phase et un conducteur de neutre. Le compteur comporte classiquement, pour chaque conducteur de phase, un relais de puissance pouvant être fermé ou ouvert afin de gérer la connexion entre le réseau électrique et l'installation électrique.

La fraude par contournement consiste à court-circuiter le compteur pour un ou plusieurs connecteurs de phase et éventuellement pour le conducteur de neutre. Il est possible de détecter la fraude en surveillant le courant circulant dans le conducteur de neutre. Le fait que la somme des courants circulant dans le(s) conducteur(s) de phase et dans le conducteur de neutre soit non nulle est indicatif de fraude.

La détection de fraude est plus complexe lorsqu'elle porte sur tous les conducteurs, de phase et de neutre. Dans ce cas, il est connu d'ouvrir le ou les relais de puissance et de mesurer la tension aux bornes du ou des relais. La tension aval (côté installation électrique) devrait être très faible par rapport à la tension amont (côté réseau). Une différence de potentiel faible entre les points amont et aval indique un contournement sur le connecteur de phase concerné.

Cette méthode n'est cependant pas applicable dans le cas des installations modernes pouvant fonctionner en mode production d'énergie. En effet, dans ce cas, la présence d'une tension élevée côté installation, lorsque le relais de puissance est ouvert, n'est pas nécessairement une anomalie.

La présente divulgation apporte une solution pour les installations pouvant fonctionner en mode production d'énergie.

### RESUME

Les revendications indépendantes définissent plusieurs aspects de la présente divulgation. De plus, d'autres aspects ou modes de réalisation sont définis dans les revendications dépendantes.

Un premier aspect de la présente divulgation concerne un procédé de détection de fraude par contournement dans une installation électrique reliée à un réseau électrique via un compteur électrique, le réseau électrique comportant un ou plusieurs conducteurs de phase et un conducteur de neutre, l'installation électrique étant configurée pour fonctionner en mode consommation d'énergie ou en mode production d'énergie, et le compteur comportant un relais de puissance sur chaque conducteur de phase. Le procédé décrit ici comporte les opérations suivantes : une détermination de fonctionnement de l'installation en mode production d'énergie; une ouverture du ou des relais de puissance; une mesure du courant circulant dans le conducteur de neutre, et une génération d'alerte en fonction de ladite mesure lorsque le courant circulant dans le conducteur de neutre est supérieur à un second seuil.

Lorsque le ou les relais sont ouverts le courant circulant dans le conducteur de neutre est normalement très faible. Un courant non nul dans le conducteur de neutre indique un contournement d'au moins un conducteur de phase et éventuellement un contournement du conducteur de neutre (le courant se partage alors entre le contournement et le conducteur de neutre).

Ce procédé de détection de fraude est adapté à des installations pouvant fonctionner en mode consommation d'énergie (l'énergie est alors importée du réseau vers l'installation) ou en mode production d'énergie (l'énergie est alors exportée de l'installation vers le réseau). Il permet de détecter la fraude lorsqu'au moins un conducteur de phase est contourné. La détection de fraude se fait en mode production d'énergie. Cette solution est avantageuse car elle évite d'ouvrir le ou les relais de puissance lorsque l'installation est en mode consommation d'énergie. L'utilisateur n'est donc pas perturbé par l'ouverture du ou des relais : il ne subit aucune coupure. Lorsque l'installation est en mode production d'énergie et que le ou les relais sont ouverts, l'énergie produite est réutilisée dans l'installation. L'ouverture du ou des relais n'entraîne donc pas de perte énergétique.

Ce procédé présente aussi l'avantage d'être simple, de ne pas nécessiter de composants supplémentaires par rapport aux compteurs existants et donc de ne pas impliquer de surcoût.

Dans un mode de réalisation, ces opérations sont répétées périodiquement tant qu'aucune alerte n'a été générée. Par exemple, elles peuvent être répétées toutes les heures. L'objectif est ici de ne pas ouvrir les relais de puissance trop fréquemment.

Dans un mode de réalisation, le procédé comporte un calcul d'une puissance active globale associée au(x) conducteur(s) de phase, et la détermination de fonctionnement en mode production se fait lorsque la puissance active globale est négative pendant une durée prédéfinie.

Dans un mode de réalisation, l'ouverture du ou des relais de puissance a lieu après vérification que le courant circulant dans le conducteur de neutre est supérieur à un premier seuil. Ce mode de réalisation est avantageux dans le cas d'un réseau polyphasé, pour éviter toute fausse alerte due à un déséquilibre normal entre les phases du réseau entraînant un courant non nul, mais normal, sur le conducteur de neutre.

Un autre aspect de la présente divulgation concerne un dispositif électrique destiné à être monté entre un réseau électrique et une installation électrique, le réseau électrique comportant un ou plusieurs conducteurs de phase et un conducteur de neutre, et l'installation électrique étant configurée pour fonctionner en mode consommation d'énergie ou en mode production d'énergie. Le dispositif comporte un relais de puissance sur chaque conducteur de phase, monté entre le réseau électrique et l'installation électrique, et au moins un ensemble à microprocesseur configuré pour effectuer les opérations décrites ci-dessus.

Un autre aspect concerne un produit programme d'ordinateur comportant des instructions qui lorsqu'elles sont exécutées par au moins un processeur causent la mise en oeuvre du procédé de détection de fraude décrit plus haut.

Un autre aspect concerne un support de stockage non transitoire lisible par un ordinateur comportant des instructions qui lorsqu'elles sont exécutées par un processeur causent la mise en oeuvre du procédé de détection de fraude décrit plus haut.

### BREVE DESCRIPTION DES FIGURES

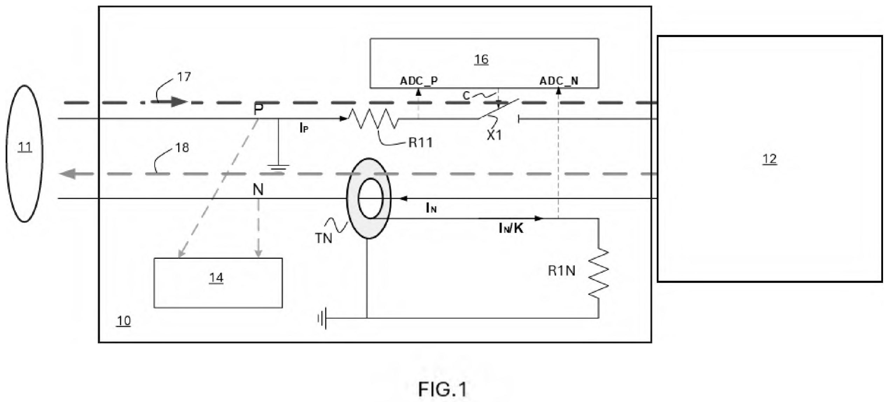

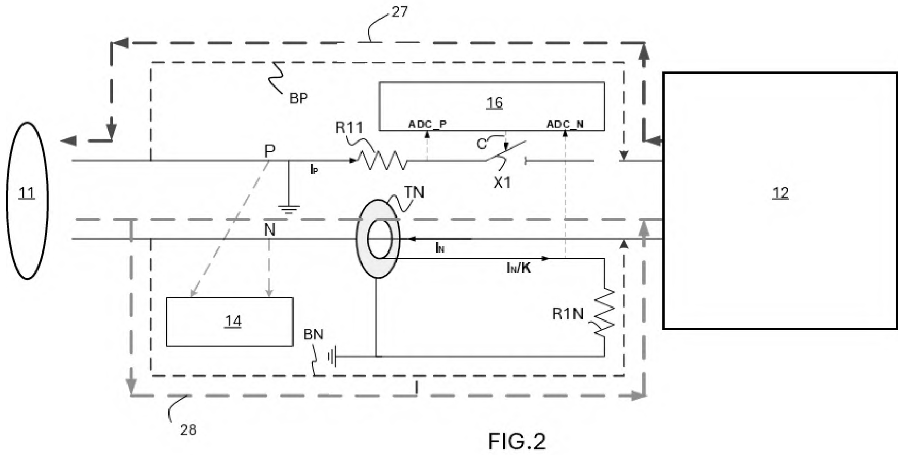

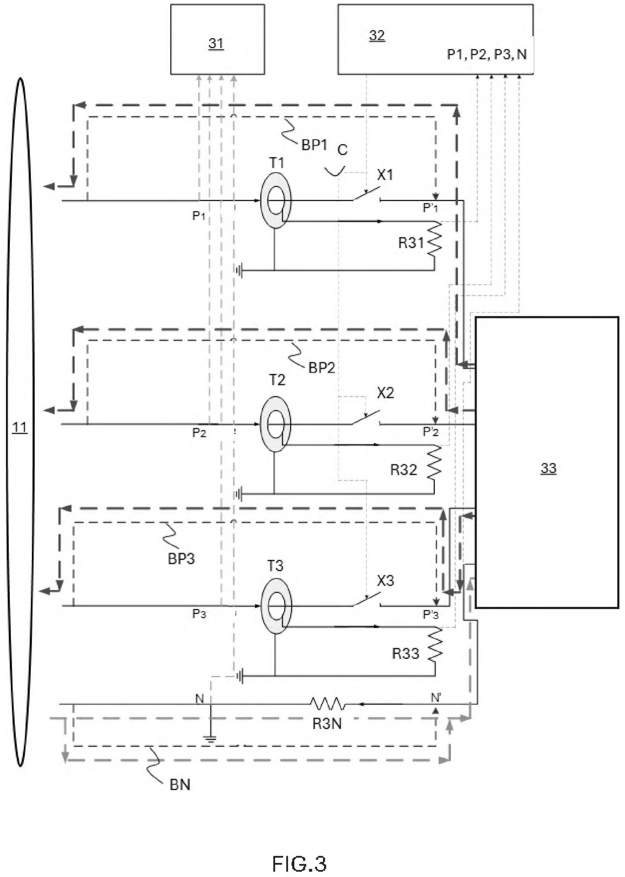

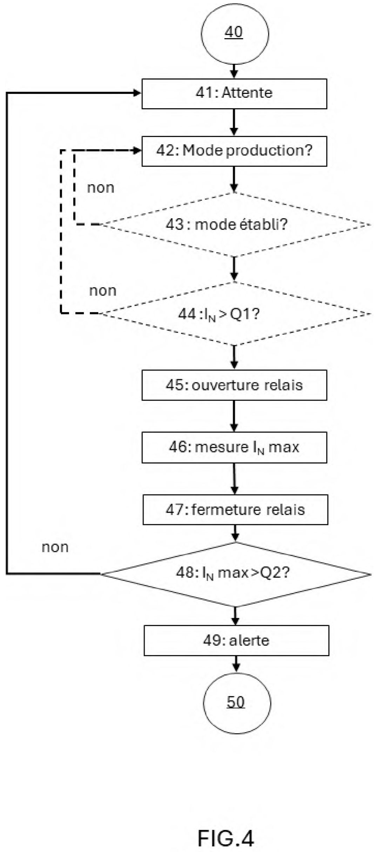

Les exemples de réalisation seront mieux compris à la lumière de la description détaillée qui va suivre et des dessins qui l'accompagnent, lesquels sont donnés à titre d'illustration uniquement et ne sont donc pas limitatifs de la présente divulgation.
La figure FIG.1 est un schéma bloc d'un premier exemple de dispositif électrique selon la présente divulgation, dans le cas d'un réseau monophasé, en l'absence de fraude.
La figure FIG.2 est un schéma bloc du même exemple de dispositif électrique que celui de la figure FIG.1, dans le cas d'une fraude par contournement du conducteur de phase et du conducteur de neutre.
La figure FIG.3 est un schéma bloc d'un second exemple de dispositif électrique selon la présente divulgation, dans le cas d'un réseau triphasé, avec fraude par contournement des conducteurs de phases et du conducteur de neutre.
La figure FIG.4 est un organigramme d'un procédé de détection de fraude destiné à être mis en oeuvre dans un dispositif du type de celui décrit sur les figures FIG.1 à FIG.3.

### DESCRIPTION DETAILLEE

Divers exemples de réalisation vont maintenant être décrits plus en détail, à titre non limitatif, en référence aux dessins qui accompagnent la présente divulgation et qui illustrent certains exemples de réalisation.

La figure FIG.1 décrit un dispositif électrique 10 monté entre un réseau électrique monophasé 11 et une installation électrique 12. Le réseau 11 comporte un conducteur de phase P, qui dans cet exemple de réalisation est relié à la masse, et un conducteur de neutre N, qui dans cet exemple est relié au point de tension haut (typiquement 230V). Le dispositif 10 comporte également une alimentation 14 reliée aux deux connecteurs P et N, et un microprocesseur 16. Le microprocesseur 16 a au moins une fonction de métrologie, c'est-à-dire de mesure des courants et tensions en divers points et de calcul de l'énergie importée et de l'énergie exportée par l'installation 12 (typiquement le microprocesseur 16 comporte des capteurs et un convertisseur analogique-numérique pour obtenir des échantillons à une fréquence d'échantillonnage à partir desquels il effectue les calculs). Une résistance de mesure R11 (shunt en anglais) est montée sur le connecteur de phase P en amont d'un relais de puissance X1 connecté à l'installation 12. La résistance de mesure R11 permet de mesurer un courant I_{P} qui traverse le conducteur de phase P. Le relais de puissance X1 permet de déconnecter l'installation 12 du réseau 11. Un transformateur TN, de rapport K (typiquement 2000), est monté sur le conducteur de neutre N. Une résistance R1N (typiquement 10 Ohms) relie le secondaire du transformateur TN à la masse. La mesure de la tension aux bornes de la résistance R1N permet de déterminer le courant I_{N}/K et donc de déduire le courant I_{N} qui circule sur le conducteur N. L'utilisation d'un transformateur sur le conducteur de neutre est nécessaire afin de garantir l'isolement entre le conducteur de phase et le conducteur de neutre. Le microprocesseur 16 commande le relais de puissance X1 comme indiqué par la flèche C. Sur la Figure FIG.1, l'installation 12 fonctionne en mode consommation : le courant dans le conducteur de phase circule du réseau 11 vers l'installation 12 (flèche 17). Le courant dans le connecteur de neutre circule de l'installation 12 vers le réseau 11 (flèche 18).

La figure FIG.2 reprend le même exemple de dispositif électrique que celui de la figure FIG.1, dans le cas d'une fraude par contournement du conducteur de phase P et du conducteur de neutre N. Les contournements du conducteur de phase P et du conducteur de neutre N sont respectivement référencés BP et BN. Sur la figure FIG.2 on se place dans le cas où l'installation fonctionne en mode production d'énergie et le relais de puissance X1 est ouvert : le courant circule via le contournement BP de l'installation 12 vers réseau 11 (flèche 27), et dans le contournement BN du réseau 11 vers installation 12 (flèche 28). Une partie du courant circule également sur le conducteur de neutre N du réseau 11 vers installation 12.

Sur la figure FIG.3, on a représenté un second exemple de dispositif électrique selon la présente divulgation, dans le cas d'un réseau triphasé, avec fraude par contournement des conducteurs de phases et du conducteur de neutre. Dans cet exemple, le réseau comporte trois conducteurs de phases P1, P2 et P3 et un conducteur de neutre N. Les conducteurs de phase P1, P2 et P3 sont reliés au point de tension haut. Le conducteur de neutre N est relié à la masse. Le dispositif comporte également une alimentation 31 reliée aux quatre conducteurs et un microprocesseur 32 qui, comme le microprocesseur 16, a au moins une fonction de métrologie, c'est-à-dire de mesure des courants et tensions en divers points et de calcul à partir de ces mesures. Dans ce mode de réalisation, une résistance de mesure R3N (shunt en anglais) est montée sur le connecteur de neutre N entre le réseau 11 et l'installation 33. La résistance de mesure R3N permet de mesurer un courant I_{N} qui traverse le conducteur de neutre N. Sur chaque connecteur de phase P1, P2 et P3 respectivement, sont montés un transformateur de mesure T1, T2, et T3 respectivement, en série avec un relais de puissance X1, X2 et X3 respectivement. Les trois relais de puissance X1, X2, et X3 servent à déconnecter l'installation 33 du réseau 11. Ils sont commandés par une même commande C fournie par le microcontrôleur 32. Comme décrit précédemment pour le réseau monophasé, les résistances R31, R32, et R33 montées sur les secondaires des transformateurs T1, T2 et T3 permettent d'obtenir le courant circulant sur chacun des connecteurs de phase P1, P2, et P3. Sur la figure FIG.3, on a également représenté les contournements BP1, BP2, BP3 et BN pour les quatre conducteurs.

Outre les fonctions métrologiques citées plus haut, le microprocesseur représenté aux figures FIG.1 à FIG.3 peut être configuré pour implémenter le procédé de détection de fraude par contournement qui va être décrit ci-dessous. Il est aussi possible d'utiliser un microprocesseur applicatif distinct pour implémenter les fonctions de détection de fraude à partir de données communiquées par le microprocesseur métrologique.

Un exemple de réalisation d'un algorithme de mise en oeuvre d'un procédé de détection de fraude par contournement selon la présente divulgation est représenté sur la figure FIG.4. Cet algorithme utilise un premier seuil de courant noté Q1, égal par exemple à 500mA, et un second seuil de courant noté Q2, égal par exemple à 250mA. Dans un mode de réalisation, la valeur des seuils de courant Q1 et Q2 est programmable. L'algorithme débute en 40, le ou les relais de puissance X1 à X3 étant fermés. En 41, on attend pendant une durée prédéterminée par exemple 1h. Cette phase d'attente est destinée à éviter que le ou les relais de puissance soient ouverts trop souvent en mode production. En 42, on détermine si l'installation fonctionne en mode production. Le mode de fonctionnement production est détecté lorsque la puissance active globale associée au(x) conducteur(s) de phase est négative (c'est-à-dire la somme des puissances actives sur chaque phase). Avantageusement, en 43, il est vérifié que le mode de fonctionnement production est établi, par exemple que l'installation fonctionne en mode production depuis un certain temps, par exemple 60s. Si la puissance active globale n'est pas négative pendant une durée suffisante (60s dans cet exemple), l'algorithme reprend en 42. Sinon, il se poursuit en 44. L'étape 44 est optionnelle, particulièrement avantageuse dans le cas d'un réseau polyphasé. En 44, on vérifie si le courant qui circule sur le conducteur de neutre I_{N} est supérieur au premier seuil Q1. Par exemple cela peut être fait en vérifiant si le premier seuil Q1 est atteint au moins une fois sur une durée de, par exemple, 10s. Dans la négative, l'algorithme reprend en 42. Sinon, il se poursuit en 45. En 45, une commande est envoyée par le microprocesseur pour ouvrir le ou les relais de puissance. Puis en en 46, le courant de neutre maximum est mesuré. Cela peut se faire par exemple, en déterminant une valeur de courant de neutre toutes les secondes et en retenant la valeur maximum parmi les dix mesures obtenues. Puis en 47, on ferme le ou les relais de puissance et en 48, on vérifie si la valeur de courant de neutre retenue est supérieure au second seuil Q2. Dans la négative, aucune fraude n'est détectée : l'algorithme reprend en 41. Sinon en 49 une alerte est générée afin d'être transmise au gestionnaire du réseau électrique via un modem du dispositif électrique. L'algorithme se termine en 50.

Les détails structurels et fonctionnels spécifiques décrits ici constituent des exemples non limitatifs. Ils peuvent faire l'objet de diverses modifications, formes alternatives, ajout ou suppression sans s'écarter de la portée de la divulgation telle que déterminée sur la base des revendications et de leurs équivalents.

Tout système de traitement de données adapté peut être utilisé pour l'implémentation. Un système ou dispositif de traitement de données adapté comprend par exemple une combinaison de code logiciel et de circuits, tels un processeur, contrôleur ou autre circuit adapté pour exécuter le code logiciel. Lorsque le code logiciel est exécuté, le processeur ou contrôleur conduit le système ou dispositif à mettre en oeuvre tout ou partie des fonctionnalités des blocs et/ou des phases des procédés selon les exemples de réalisation. Le code logiciel peut être stocké dans une mémoire non volatile ou sur un support de stockage non volatile (clé USB, carte mémoire ou autre support) lisible directement ou à travers une interface adaptée par le processeur ou contrôleur.

Par exemple, il est possible d'utiliser un ou plusieurs ensembles à microprocesseur, par exemple un premier ensemble à microprocesseur chargé des fonctions métrologiques du compteur (mesure de courant et de tension) en communication avec un second ensemble à microprocesseur chargé des fonctions applicatives du compteur, par exemple la mise en oeuvre à partir des mesures fournies par le premier microprocesseur du procédé de détection de fraude par contournement tel que décrit ici.

Les avantages et les solutions aux problèmes ont été décrits ci-dessus en ce qui concerne des modes de réalisation spécifiques de l'invention. Ils ne doivent pas être interprétés comme une caractéristique ou un élément critique, requis, ou essentiel de l'une ou de l'ensemble des revendications.

## Revendications

1. Dispositif électrique destiné à être monté entre un réseau électrique et une installation électrique, le réseau électrique comportant un ou plusieurs conducteurs de phase et un conducteur de neutre, et l'installation électrique étant configurée pour fonctionner en mode consommation d'énergie ou en mode production d'énergie, le dispositif comportant un relais de puissance sur chaque conducteur de phase, monté entre le réseau électrique et l'installation électrique, et au moins un ensemble à microprocesseur configuré pour effectuer les opérations suivantes :
- déterminer que l'installation électrique fonctionne en mode de production d'énergie,
- ouvrir le ou les relais de puissance,
- obtenir une mesure du courant circulant dans le conducteur de neutre, et
- générer une alerte en fonction de ladite mesure lorsque le courant circulant dans le conducteur de neutre est supérieur à un second seuil.

2. Dispositif selon la revendication 1, **caractérisé en ce que** le au moins un ensemble à microprocesseur est configuré pour répéter lesdites opérations périodiquement tant qu'aucune alerte n'a été générée.

3. Dispositif selon l'une des revendications 1 ou 2, **caractérisé en ce que** le au moins un ensemble à microprocesseur est configuré pour calculer une puissance active globale associée au(x) conducteur(s) de phase, et pour déterminer que l'installation électrique fonctionne en mode de production d'énergie lorsque la puissance active globale est négative pendant une durée prédéfinie.

4. Dispositif selon l'une des revendications 1 à 3, **caractérisé en ce que** le au moins un ensemble à microprocesseur est configuré pour, avant d'ouvrir le ou les relais de puissance, vérifier que le courant circulant sur le conducteur de neutre est supérieur à un premier seuil.

5. Procédé de détection de fraude par contournement dans une installation électrique reliée à un réseau électrique via un compteur électrique, le réseau électrique comportant un ou plusieurs conducteurs de phase et un conducteur de neutre, l'installation électrique étant configurée pour fonctionner en mode consommation d'énergie ou en mode production d'énergie, et le compteur comportant un relais de puissance sur chaque conducteur de phase, **caractérisé en ce qu'**il comporte les opérations suivantes :
- une détermination de fonctionnement de l'installation en mode producteur d'énergie,
- une ouverture du ou des relais de puissance,
- une mesure du courant circulant dans le conducteur de neutre, et
- une génération d'alerte en fonction de ladite mesure lorsque le courant circulant dans le conducteur de neutre est supérieur à un second seuil.

6. Procédé selon la revendication 5, **caractérisé en ce que** lesdites opérations sont répétées périodiquement tant qu'aucune alerte n'a été générée.

7. Procédé selon l'une des revendications 5 ou 6, **caractérisé en ce qu'**il comporte un calcul d'une puissance active globale associée au(x) conducteur(s) de phase, et **en ce que** ladite détermination se fait lorsque la puissance active globale est négative pendant une durée prédéfinie.

8. Procédé selon l'une des revendications 5 à 7, **caractérisé en ce que** l'ouverture du ou des relais de puissance a lieu après vérification que le courant circulant sur le conducteur de neutre est supérieur à un premier seuil.

9. Produit programme d'ordinateur comportant des instructions qui lorsqu'elles sont exécutées par au moins un processeur causent la mise en oeuvre d'un procédé selon l'une quelconque des revendications 5 à 8.

10. Support de stockage non transitoire lisible par un ordinateur comportant des instructions qui lorsqu'elles sont exécutées par un processeur causent la mise en oeuvre d'un procédé selon l'une quelconque des revendications 5 à 8.
